# EUROPEAN PATENT APPLICATION

(11) **EP 1 475 464 A1**
(43) Date of publication of application: **10.11.2004**
(21) Application number: 03291088.7
(22) Date of filing: 06.05.2003
(51) Int. Cl.: C30B 11/00, C30B 29/12

(54) **Method for producing an optical fluoride crystal**

(71) Applicant: CORNING INCORPORATED, Corning, N.Y. 14831 (US)
(72) Inventor: Meyer-Fredholm, Michele Marie-Louise, 77850 Hericy (FR); Pell, Michael Alan, Singapore 138676 (SG); Price, Michael William, Corning, NY 14830 (US)
(74) Representative: Poole, Michael John

(57) **Abstract**

A method for producing an optical fluoride crystal includes translating a crucible containing a molten crystal raw material from a first zone, through a thermally-graded zone, into a second zone to form a crystal and controlling a temperature of at least one of the first zone and the second zone such that an effective radial temperature gradient at a point in the thermally-graded zone where the crystal is formed does not exceed 5 °C/cm.

## Description

### Field of the Invention

The invention relates to optical crystals and to a method for producing a fluoride crystal suitable for use in the vacuum ultraviolet region.

### Background of the Invention

Fluoride crystals are useful materials because of their low-wavelength absorption edges. Properly grown crystals have a high transmission in the vacuum ultraviolet region of the electromagnetic spectrum; that is, at wavelengths below 230 nm. The main demand for such fluoride crystals comes from the microlithography industry. These fluoride crystals can be used for manufacturing optics and optical components for use in excimer lasers, and also optical components for use in projection and illumination systems. The resolution of the microlithography process is such that optical materials used in exposure systems must be of impeccable quality. Typically, birefringence should be less than 3 nm/cm and optical homogeneity should be less than 3 ppm. To obtain crystals of such quality, a great deal of attention must be paid to the growth process.

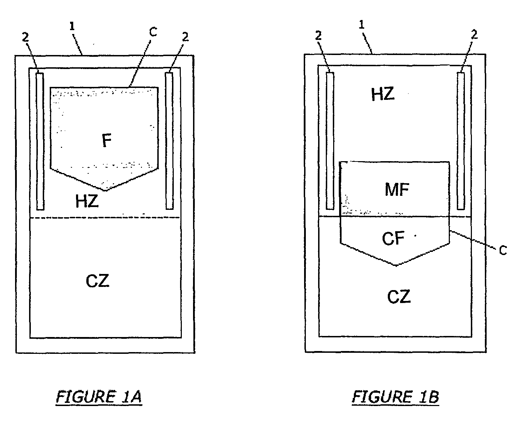

Single fluoride crystals are commonly grown using the Stockbarger-Bridgeman process. This process is described with reference to Figures 1A and 1B. In Figure 1A, a fluoride raw material F is loaded into a crucible C, which is disposed inside a hot zone HZ of a vertical furnace 1. The hot zone HZ is then heated to a temperature sufficient to melt the fluoride raw material F. After melting the fluoride raw material F, the crucible C is slowly lowered from the hot zone HZ to a cold zone CZ, as shown in Figure 1B. As the crucible C passes from the hot zone HZ to the cold zone CZ, the molten material F goes through a zone of thermal gradient. On passing through this zone, the temperature transition inside the molten material F creates a crystal front CF. The crystal front CF propagates inside the crucible C, within the material F, as long as the crucible C is caused to move in a downward direction.

In the technique described above, the melt is generally exposed to sharp localized cooling as it is translated from the hot zone to the cold zone. Such sharp localized cooling generates thermal strain in the crystal, which results in unacceptably elevated values in birefringence and optical homogeneity. To reduce thermal strain in the crystal an annealing process typically follows the growth process described above. In the annealing process the crystal is first heated to a temperature below its melting point. The crystal is then held at this temperature for a given period of time in a homogeneous temperature field before being slowly cooled to room temperature. This allows the thermal strain in the crystal to be dissipated.

However, the annealing process described above is a very long process, lasting several days. In addition, the process of re-heating the crystal and holding it at a high temperature for a long time can result in defects in the crystal, which in turn can lead to lower transmission in the crystal. In view of the length of time for conventional annealing and the economic losses incurred when crystals develop defects, a process which does not require annealing, or greatly shortens the time required for the annealing process, is desirable.

### Summary of the Invention

In one aspect, the invention is directed to a method for producing an optical fluoride crystal in which a crucible containing a molten raw material is translated (moved) from a first zone through a thermally-graded zone into a second zone to thereby form an optical fluoride crystal, and controlling a temperature of at least one of the first zone and the second zone such that an effective radial temperature gradient at a point in the thermally-graded zone where the crystal is formed does not exceed 5 °C/cm.

In another aspect, the invention is directed to a method for producing an optical fluoride crystal in which a crucible containing a molten crystal raw material is translated from a first zone through a thermally-graded zone into a second zone to form a crystal, and controlling a temperature of at least one of the first zone and the second zone such that an effective radial and axial temperature gradients at a point in the thermally-graded zone where the crystal is formed does not exceed 5 °C/cm and 10 °C/cm, respectively.

Other features and advantages of the invention will be apparent from the following description and the appended claims.

### Brief Description of the Drawings

Figures 1A and 1B illustrate a process for forming a crystal.

Figure 2 illustrates a furnace for growing a crystal.

Figure 3 show a stack of crucibles within a furnace.

Figure 4 shows a crystal being formed as the crucible of Figure 2 is translated through a thermal gradient zone.

### Detailed Description

A method consistent with the principles of the invention minimizes rapid localized cooling of a crystal melt during the crystal growth process. The invention works by carefully controlling the shape of the crystallization front at the growth interface while simultaneously providing a uniform temperature field in the cold zone without abruptly cooling the crystals. Crystals grown under such conditions can have a birefringence less than 2 nm/cm and optical homogeneity less than 2 ppm. Therefore, further heat treatment to relieve thermal strain can be eliminated.

Figures 1A illustrates a crucible containing a fluoride raw material in a furnace hot zone where the material is melted. Figure 1B illustrates the crucible partially translated into the cold zone. Within the crucible a crystal from has grown and molten material remains above the crystal front. As the crucible continues to be translated into the cold zone the crystal continues to grow until the crucible is completely in the cold zone and all the molten material within the crucible has crystallized.

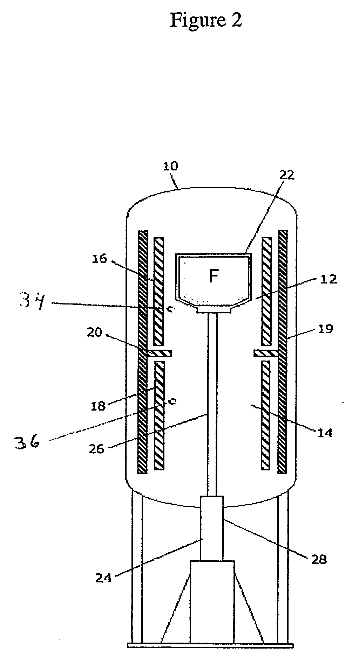

Figure 2 shows an environment suitable for practice of the invention, including a vertical furnace 10 having an upper zone 12 and a lower zone 14. A heating element 16 is provided in the upper zone 12 to maintain an appropriate temperature in the upper zone 12. A heating element 18 is also provided in the lower zone 14 to maintain an appropriate temperature in the lower zone 14. The temperature of upper and lower zones 12 and 14 can be monitored by the use of temperature measuring elements 34 and 36, for example, thermocouples 34 and 36. Elements 34 and 36 can simply monitor the temperature in each zone, or they can be linked to a controller to control the temperature of each zone. Insulating material 19 is provided around the heating elements 16, 18 to contain heat in the furnace 10. In an alternate embodiment, additional insulation may be provided in the lower zone 14 to allow an appropriate temperature to be maintained within the lower zone 14. This insulation can be used in addition to or in lieu of the heating element 18. In alternate embodiments, multiple heaters can be provided in either or both of the upper zone 12 and lower zone 14 to maintain the required temperatures in the zones 12, 14. Preferably, the heating element 18 in the lower zone 14 can be controlled independently of the heating element 16 in the upper zone 12.

A diaphragm or baffle 20, made of an insulating material, is disposed between the upper zone 12 and the lower zone 14, between the heating elements 16, 18. The diaphragm 20 partially isolates the upper zone 12 from the lower zone 14, creating a thermal gradient zone between the upper zone 12 and the lower zone 14. The vertical temperature gradient across the diaphragm 20 is dependent on the geometry of the furnace 10; that is, the length of the heating elements 16, 18, the vertical distance between the heating elements 16, 18, the insulation in the furnace 10, and the temperatures in the upper and lower zones 12, 14. It should be noted that the heating element 18 does not have to extend across the entire length of the lower zone 14; that is, a short heating element can be used in the lower zone 14, just below the diaphragm 20. Provision can be made for cold water to circulate inside the diaphragm 20 to obtain a temperature gradient of more sizable intensity.

In the method of the invention, a crucible 22 is disposed inside the upper zone 12. The crucible 22 contains a crystal raw material or melt F. In one embodiment, the crystal raw material F is a feedstock for preparing fluoride crystals, for example single crystals of CaF₂, BaF₂, SrF₂, LiF, MgF₂, or NaF; or for preparing crystals containing a mixture of these crystals. For example, CaF₂ powder and SrF₂ powder are mixed together, melted and solidified to form a CaSrF₂ single crystal.

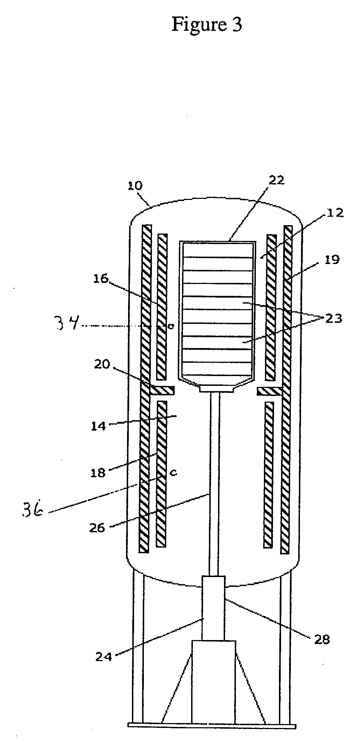

The crucible 22 may be a single unit or may be divided into several vertically stacked bowls (elements 23 in Figure 3). Typically, the stacked bowls (elements 23 in Figure 3) would communicate through openings in the center of bottoms, except for the botton bowl which has no opening. The opening are approxmately 3-4 mm in diameter. Each bowl is filled to capacity and stack is placed in the furnace. As the charge melts and densifies, it flows downwards filling the bowl below it. The bottom bowl contains a seed crystal to initiate crystal formation. Crystallization occurs from the bottom bowl upward and as the material in each bowl completes its crystallization it provides, via the opening between it and the bowl above it, the seed for crystallizing the material inthe bowl bowl above it. By using a series of stacked bowls one is able to grow a plurality of crystalline disks rather than a single, large cylindrical crystal as is usually carried out in the art.

In an alternate embodiment, a charging device or reservoir (not shown) may be provided to fill the stacked bowls with the molten material. Typically, this reservoir is filled with powdered material which melts, densifies and flows into the top bowl through an opening in the reservoir bottom. Flow continues through the bowls as described above until each bowl is filled.

A lift mechanism 24 is coupled to the crucible 22 to lower the crucible 22 from the upper zone 12, through the diaphragm 20, into the lower zone 14. As an example, the lift mechanism 24 could be a rod 26 coupled to a hydraulic or pneumatic actuator 28. The actuator 28 may be controlled as necessary to translate the crucible 22 inside the furnace 10.

The invention is based in part on the discovery that radial temperature gradients can result in deformation of the crystal growth interface. A highly concave or convex interface can result in spurious grain formation and high birefringence due to nonuniformity in cooling the interface. Preferably, the radial temperature gradient at the crystal growth interface is no greater than 5 °C/cm. Also, sufficient axial, or vertical, thermal gradient at the diaphragm 20 is needed to grow the crystal. However, the axial thermal gradient should not be so high that it causes rapid localized cooling in the molten material F. Preferably, the axial temperature gradient at the diaphragm 20, that is, within the thermal gradient zone, is no greater than 10 °C/cm.

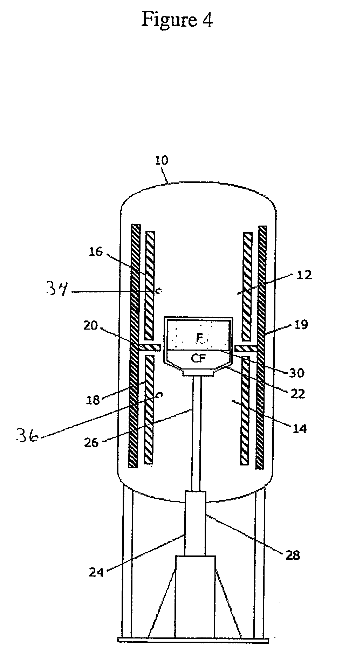

In operation, the furnace 10 is hermetically sealed and the required atmosphere is created inside the upper zone 12. This atmosphere can be a vacuum, an inert atmosphere (helium, argon or other inert atmosphere) or a fluorinating atmosphere. The upper zone 12 is then heated to a temperature sufficient to melt the content of the crucible 22 or maintain the content of the crucible 22 in a molten condition. For example, for CaF₂, the temperature is typically set at 1500 °C or higher. The crucible 22 with the molten material is slowly translated from the upper zone 12, through the diaphragm 20, into the lower zone 14. The lower zone 14 is maintained at a temperature lower than the temperature in the upper zone 12 so that there is a temperature gradient across the diaphragm 20. As the crucible 22 passes through the diaphragm 20, the molten material F goes through the zone of thermal gradient. As shown in Figure 4, on passing through this zone, the temperature transition inside the molten material F creates a crystal front CF. The crystal front CF propagates inside the crucible 22, within the molten material F, as long as the crucible 22 continues to move in a downward direction into the lower zone 14.

As the crucible 22 passes through the temperature gradient zone, defined at the diaphragm 20, it is important that the content of the crucible 22 does not experience a rapid drop in temperature. Preferably, the effective axial temperature gradient at the crystal growth interface 30, that is, the interface between the molten material F and the crystal front CF, does not exceed 10 °C/cm. Preferably, the effective radial temperature at the crystal growth interface 30 does not exceed 5 °C/cm. Control of both axial and radial temperature gradients at the crystal growth interface and uniform temperature in the lower zone 14 can be achieved by the heating element 18 and/or having a highly insulated lower zone 14. To ensure a sufficient axial temperature gradient at the crystal growth interface, the temperature of the lower zone 14 is preferably held at a temperature greater than 550 °C below the melting temperature of the crystal raw material but not more than 100 °C below the melting temperature of the crystal raw material.

When the entire crucible mass 22 has moved into the effective area of the lower zone 14, the crystal can be cooled directly to room temperature without re-heating. The cooling rate of the crystal should be less than 15 °C/h (°C/hour). Preferably, the cooling rates should be in the range of 1-10 °C/hour and the time for cooling to room temperature would be in the range of 10-30 days. The exact time for cooling will be dependent on the rate at which cooling occurs. For example, at a cooling rate of approximately 3°C/hour, the time will be approximately 17 days.

The cooling rate can also be divided into several independent steps. For example, at temperatures above 700 °C, the cooling rate should preferably be in the range of 1-4 °C/hour, and more preferably no greater than 2.5-3.0 °C/h. At temperatures below 700 °C and above 550 °C, the cooling rate should preferably be in the range of 1-6 °C, and more preferably no greater than 5 °C/h. At temperatures below 550 °C and above 400 °C, the cooling rate should generally not exceed 10 °C/h. It is efficient to increase the cooling rate when the temperature is below 400°C to greater than 10 °C/h. This cooling schedule ensures that the crystal is not cooled too rapidly.

The following example is presented for illustration purposes and is not intended to limit the invention as otherwise described herein.

### EXAMPLE

A 300-mm diameter CaF₂ crystal disk was grown in a furnace equipped with independently controlled heaters in the upper and lower zones. The zones were separated by a diaphragm. The temperature of the upper heater was set at 1500 °C. The temperature of the lower heater was set at 1250 °C. The calcium fluoride raw material was loaded into a crucible and melted in the upper zone by ramping the heater setpoints over a period of 4-6 days. The crucible was then lowered at 2.5 mm/hr through the diaphragm region, where crystallization occurred, and then into the lower zone. Once in the lower zone, the crystalline material was directly cooled to room temperature in 17 days at a rate of 3 °C/hour over a 17 day period. The furnace used in this experiment employs a heater that is 2-3 time the length of the crystal in order to provide the correct thermal environment for cooling the crystals. This heater provides a thermal environment with a <10 °C/cm axial thermal gradient and a < 5 °C/cm radial thermal gradient. During cooling the upper and lower heater temperatures are maintained within approximately 100 °C of each other in order to achieve the desired thermal gradients. However, as an option, during the first part of the cooling, the heater temperatures can be as much a 250 °C apart, with the provision that within 1-2 days after the start of the cooling/crystallization cycle the heater temperatures are brought to within 100 °C of each other and maintained within this difference during the process until lower temperatures (less than 550 °C) are reached. It is also noted that optionally one can increase the cooling rate, for example to approximately 10 °C/hour, at temperature below 550 °C. No further heat treatment steps were performed. The crystals obtained from this process have less than 1 nm/cm birefringence and less than 2 ppm optical homogeneity.

While the invention has been described with respect to a limited number of embodiments, those skilled in the art, having benefit of this disclosure, will appreciate that other embodiments can be devised which do not depart from the scope of the invention as disclosed herein. Accordingly, the scope of the invention should be limited only by the attached claims.

## Claims

1. A method for producing an optical fluoride crystal, comprising:
translating a crucible containing a molten crystal raw material from a first zone, through a thermally-graded zone, into a second zone to form a crystal; and
controlling a temperature of at least one of the first zone and second zone such that an effective radial temperature gradient at a point in the thermally-graded zone where the crystal is formed does not exceed 5 °C/cm.

2. The method of claim 1, further comprising controlling a temperature difference between the first zone and the second zone such that an effective axial temperature gradient in the thermally-graded zone does not exceed 10 °C/cm.

3. The method of claim 1 or claim 2, wherein controlling the temperature or the temperature difference comprises controlling a heating element in the second zone.

4. The method of claim 1 or claim 2, wherein controlling the temperature or the temperature difference between the first zone and the second zone comprises heavily insulating the second zone.

5. The method of any one of the preceding claims, wherein the first zone is maintained at a temperature above a melting point of the crystal raw material.

6. The method of any one of claims 1-5, wherein the temperature in the second zone is maintained in a range from 100 to 550 °C below a melting point of the crystal raw material.

7. The method of any one of the preceding claims, further comprising cooling the crystal in the second zone.

8. The method of any one of claims 1-6 further comprising cooling the crystal in the second zone at a rate less than 15 °C/h.

9. The method of claim 7, wherein a cooling rate of the crystal from a temperature above 700 °C is no greater than 2.5 °C/h.

10. The method of claim 7, wherein a cooling rate of the crystal from a temperature above 550 °C is no greater than 5 °C/h.

11. The method of claim 7, wherein a cooling rate of the crystal from a temperature above 400 °C is no greater than 10 °C/h.

12. The method of any one of the preceding claims, wherein a translation rate of the crucible is 2.5 mm/hr.

13. The method of any one of the preceding claims, wherein the crystal raw material comprises one selected from the group consisting of CaF₂, BaF₂, SrF₂, LiF, MgF₂, NaF, and mixtures thereof.

14. The method of any one of the preceding claims, wherein the crucible comprises a stack of bowls, each of which contains a portion of the molten crystal raw material.

15. A method for producing an optical fluoride crystal, comprising:
translating a crucible containing a molten crystal raw material from a first zone, through a thermally-graded zone, into a second zone to form a crystal; and
controlling a temperature of at least one of the first zone and the second zone such that an effective radial and axial temperature gradient at a point in the thermally-graded zone where the crystal is formed does not exceed 5 °C/cm and 10 °C/cm, respectively.
